# EUROPEAN PATENT APPLICATION

(11) **EP 3 316 014 A1**
(43) Date of publication of application: **02.05.2018**
(21) Application number: 16829782.8
(22) Date of filing: 19.07.2016
(51) Int. Cl.: G02B 6/42, H05K 1/18, G02B 6/24

(54) **OPTICAL INTERCONNECTION BACKBOARD, TRANSMISSION DEVICE AND SIGNAL SCHEDULING METHOD**

(30) Priority: 24.07.2015 CN 201510443918
(71) Applicant: ZTE Corporation, Shenzhen, Guangdong 518057 (CN)
(72) Inventor: MEI, Junyao, Shenzhen Guangdong 518057 (CN)
(74) Representative: HGF Limited
(86) International application number: PCT/CN2016/090456
(87) International publication number: WO 2017/016416

(57) **Abstract**

An optical interconnection backboard (50), a transmission device and a signal scheduling method are provided. The optical interconnection backboard (50) includes a Printed Circuit Board (PCB) (52), an optical interconnection layer (51) including one or more optical waveguides, a Transmitter Optical Subassembly (TOSA) (53) modulating electrical signals received from the PCB (52) into optical signals, a Receiver Optical Subassembly (ROSA) (54) converting received optical signals into electrical signals and transmitting the electrical signals to the PCB (52), a first waveguide coupling module (551) coupling optical signals generated by the TOSA (53) into the optical interconnection layer (51), a second waveguide coupling module (552) coupling optical signals transmitted by the optical interconnection layer (51) into the ROSA (54), and one or more Crossbars configured to implement cross configuration from any path of inputs to any path of outputs. Each Crossbar is connected with at least one TOSA (53) and ROSA (54).

## Description

### Technical Field

The present invention relates to, but not limited to, the field of communications, and particularly to an optical interconnection backboard, transmission device and a signal scheduling method.

### Background

Along with development of an information science and technology such as a communication and computer technology, and particularly, rapid development of a high-speed information communication network in recent years, the information amount is exponentially increased, and a processing speed of a computer is required to be developed towards a high-performance computer direction of one hundred billion, a trillion and even more per second. Wideband, high-speed and high-capacity information processing and transmission makes higher requirements on an interconnection rate, bandwidth and density between Printed Circuit Boards (PCBs), between a board and a backboard and between chips in a system. Facing challenge of a transmission rate of a high-speed information communication network in the new age, an "electrical interconnection" manner of a conventional metal line is not adapted to the requirement of the high-speed information processing and transmission increasingly. Data in a computer, for example, data in a microprocessor in a chip are transmitted at an amazing rate. However, data transmission rates of lines connected between a chip and a chip and between a circuit board and a circuit board may be described by "crawling". A main working frequency of an Intel Pentium 4 processor reaches more than 4GHz, but a system bus only has hundreds of MHz. How to eliminate a bottleneck of data transmission on a circuit board is a key problem, and is a direction in which efforts will be made for in the future.

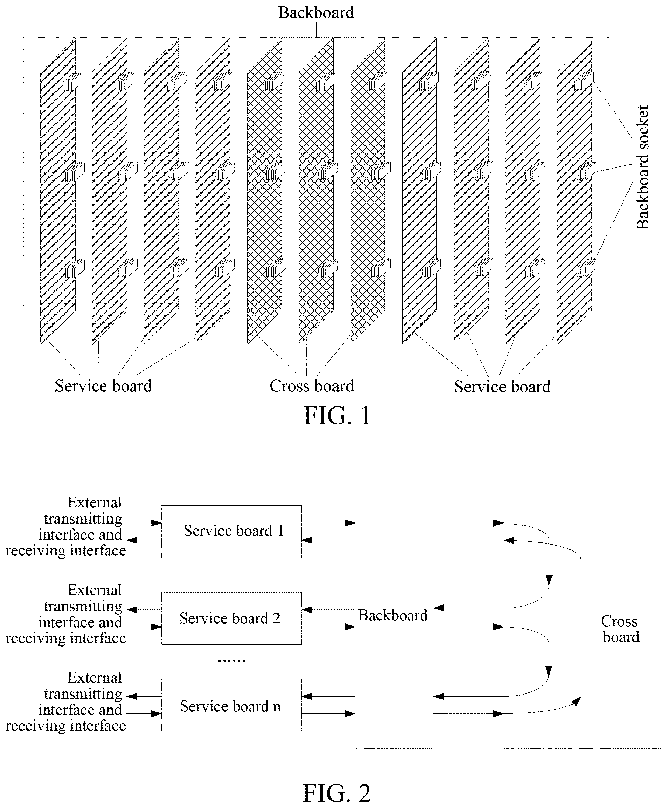

In a high-speed communication system, existing transmission device usually adopts the following structure: multiple service boards are configured to realize multiple service input/output functions; a backboard is configured to implement interconnection and intercommunication between the service boards, but the backboard is usually passive, and only provides a communication channel; one or more cross boards are configured to implement signal scheduling between the service boards; the service boards and the cross boards are PCBs, and the service boards and the cross boards include backboard sockets; and the backboard also includes backboard sockets mated with the backboard sockets on the service boards/cross boards for use to implement connection with the service boards/cross boards. The structure is shown in FIG. 1.

The service board is at least provided with a pair of external transmitting and receiving interfaces. The external receiving interface receive service signals, and the service board processes services and then transmits the services to the backboard, and then the backboard transmits the signals to the cross board. At the same time, the service board receives signals transmitted by the cross board from the backboard, and processes and transmits them out from the external transmitting interface. The service board and the cross board are directly plugged onto the backboard through the backboard sockets to implement interconnection and intercommunication with the backboard.

The cross board receives the signals, transmitted from the backboard, of the service board, and then perform scheduling forwarding. As shown in FIG. 2, all of a service board 1, a service board 2, ...... and a service board n are provided with external transmitting and receiving interfaces, and signals received by a service board through the external receiving interface are transmitted to the cross board through the backboard, and are transmitted to other service board by the cross board through the backboard, and then are transmitted through the external transmitting interface.

A limit to a cross capacity of service signals in the abovementioned transmission device mainly depends on by a present finite bandwidth bottleneck of electrical interconnection of PCBs. When high-speed signals, particularly electrical signals of a GHz level, are transmitted, loss is high, a transmission distance is short, anti-interference performance is poor, and crosstalk is serious, and in addition, the cross board is further required to perform electrical relaying on the high-speed signals received from the backboard. How to simplify a design on the premise of ensuring a signal transmission distance/quality and flexible service scheduling is a problem to be solved at present.

### Summary

The below is a summary about a subject described in detail in the present document. The summary is not intended to limit the scope of protection of the claims.

The present document provides an optical interconnection backboard, and transmission device and signal scheduling method adopting the optical interconnection backboard. A backboard and a cross board may be replaced, and flexible scheduling of a service may be implemented, and a limit to a transmission distance of a signal is not required to be considered, and adoption of electrical relaying is also not required. Therefore, a design is simplified, cost is reduced, and meanwhile, operation stability of the device is further improved.

An optical interconnection backboard includes: a PCB;
an optical interconnection layer including one or more optical waveguides;
a Transmitter Optical Subassembly (TOSA), configured to modulate an electrical signal received from the PCB into an optical signal;
a Receiver Optical Subassembly (ROSA), configured to convert a received optical signal into an electrical signal and transmit the electrical signal to the PCB;
a first waveguide coupling module, configured to couple the optical signal generated by the TOSA into the optical interconnection layer;
a second waveguide coupling module, configured to couple the optical signal transmitted by the optical interconnection layer into the ROSA; and
one or more Crossbars, configured to implement cross configuration from any path of input to any path of output, herein
each Crossbar is connected with at least one TOSA and one ROSA.

In an exemplary embodiment, the TOSA includes a laser array and a laser driving circuit chip; and the ROSA includes a photoelectric detector array and a detector driving circuit chip.

In an exemplary embodiment, lasers in the laser array are Vertical Cavity Surface Emitting Lasers (VCSELs), and photoelectric detectors in the photoelectric detector array are Positive-Intrinsic-Negative (PIN) photoelectric detectors.

In an exemplary embodiment, the lasers in the laser array are welded together with the laser driving circuit chip in a flip-chip bonding manner, and the photoelectric detectors in the photoelectric detector array are welded together with the detector driving circuit chip in the flip-chip bonding manner, and light-emitting surfaces of the lasers and light-receiving surfaces of the photoelectric detectors face the optical interconnection layer.

In an exemplary embodiment, the optical interconnection layer includes an upper cladding, a fiber core layer and a lower cladding; and the fiber core layer includes one or more optical waveguides, and each optical waveguide is arranged in parallel.

In an exemplary embodiment, the laser array includes m lasers; the photoelectric detector array includes m photoelectric detectors, the fiber core layer includes m optical waveguides, and the first waveguide coupling module and the second waveguide coupling module include m waveguide couplers respectively; m being an integer more than or equal to 1;
one end of each of the m waveguide couplers in the first waveguide coupling module corresponds to a light-emitting interface of each of the m lasers, and the other end corresponds to an input end of each of the m optical waveguides; and
one end of each of the m waveguide couplers in the second waveguide coupling module corresponds to a light-receiving interface of each of the m photoelectric detectors, and the other end corresponds to an output end of each of the m optical waveguides.

In an exemplary embodiment, the PCB is a multilayer PCB, and the optical interconnection layer is arranged below or in middle of the multilayer PCB, and the optical interconnection layer is bonded together with the multilayer PCB; and
the TOSA and the ROSA are arranged on a top layer of the multilayer PCB.

In an exemplary embodiment, a light in the optical interconnection layer forms a 90° angle with a light emitted by the TOSA and forms a 90°angle with a light received by the ROSA.

In an exemplary embodiment, the optical interconnection backboard further includes:
one or more backboard sockets, configured to provide a high-speed electrical signal interface between a service board and the optical interconnection backboard; herein
each backboard socket is connected with a Crossbar through electrical lines of the PCB in a one-to-one corresponding manner; and
each Crossbar is connected with a service board through the corresponding backboard socket in the one-to-one corresponding manner.

In an exemplary embodiment, the number of TOSAs, the number of ROSAs, the number of first waveguide coupling modules and the number of second waveguide coupling modules are all (P-1)×2, and the TOSAs are connected with the first waveguide coupling modules in the one-to-one corresponding manner, and the ROSAs are connected with the second waveguide coupling modules in the one-to-one corresponding manner; and there are P Crossbars connected with service boards in the one-to-one corresponding manner; and P being a number of the service boards;
each Crossbar is sequentially connected; each of the first and last Crossbars is connected with a TOSA and a ROSA; each of other Crossbars is connected with a TOSA and ROSA for transmission in a first direction, and connected with a TOSA and ROSA for transmission in a second direction;
the first Crossbar is connected with the ROSA, connected with a next Crossbar, for transmission in the first direction through the connected TOSA, and is connected with the TOSA, connected with the next Crossbar, for transmission in the second direction through the connected ROSA;
the last Crossbar is connected with the TOSA, connected with a previous Crossbar, for transmission in the first direction through the connected ROSA, and is connected with the ROSA, connected with the previous Crossbar, for transmission in the second direction through the connected TOSA; and
for any other two adjacent Crossbars, one Crossbar is connected with the ROSA, connected with the other Crossbar, for transmission in the first direction through the connected TOSA for transmission in the first direction, and is connected with the TOSA, connected with the other Crossbar, for transmission in the second direction through the connected ROSA for transmission in the second direction;
herein that the TOSA is connected with the ROSA means that the TOSA is connected with the second waveguide coupling module correspondingly connected with the ROSA through the correspondingly connected first waveguide coupling module and the optical interconnection layer.

In an exemplary embodiment, when P is an even number, each Crossbar has (P+1)*K pairs of electrical transmitting and receiving interfaces, and the (P+1)*K pairs of electrical transmitting and receiving interfaces includes:
K pairs of electrical transmitting and receiving interfaces for connecting the backboard sockets, P*K electrical transmitting and receiving interfaces for connecting the TOSAs and P*K electrical transmitting and receiving interfaces for connecting the ROSAs;
each TOSA includes P*K/2 lasers, and
each ROSA includes P*K/2 photoelectric detectors; and
when P is an odd number, each Crossbar has K*P pairs of electrical transmitting and receiving interfaces, and the K*P pairs of electrical transmitting and receiving interfaces includes:
   K pairs of electrical transmitting and receiving interfaces for connecting the backboard sockets, (P-1)*K electrical transmitting and receiving interfaces for connecting the TOSAs and (P-1)*K electrical transmitting and receiving interfaces for connecting the ROSAs;
   each TOSA includes (P-1)*K/2 lasers, and
   each ROSA includes (P-1)*K/2 photoelectric detectors.

In an exemplary embodiment, the Crossbars are further configured to communicate with a central Control Unit (CU) through the electrical lines of the PCB to implement cross scheduling between different electrical transmitting and receiving interfaces.

Transmission device includes: one or more service boards; and
the abovementioned optical interconnection backboard, herein
Crossbars in the optical interconnection backboard are connected with the service boards in a one-to-one corresponding manner.

A signal scheduling method is implemented on the basis of the abovementioned optical interconnection backboard, and includes that:
a Crossbar correspondingly transmits a received electrical signal to connected TOSA or electrical lines of the PCB according to a predetermined cross configuration strategy;
the TOSA modulates the electrical signal into an optical signal, and then transmitting the optical signal to the optical interconnection layer through the first waveguide coupling module;
the second waveguide coupling module couples the optical signal transmitted by the optical interconnection layer to the ROSA; and
the ROSA converts the optical signal into electrical signal, and then transmits the electrical signal to the connected Crossbar.

In an exemplary embodiment, the electrical signal received by the Crossbar includes:
an electrical signal received through the electrical lines of the PCB and an electrical signal received through the connected ROSA.

A computer-readable storage medium stores a computer-executable instruction, and the computer-executable instruction is executed by the processor to implement the abovementioned method.

Compared with a related technology, the solutions of embodiments of the present invention combine advantages of optical transmission and electrical transmission, fully utilize the advantages of high optical transmission rate, low loss, long transmission distance, high anti-interference performance and the like and flexible scheduling in an electrical layer, and integrate cross boards and backboard of conventional transmission device. Therefore, the solutions of embodiments of the present invention solve a bottleneck of limit to a cross capacity of the conventional device, effectively increase the cross capability of the transmission device and a single-channel bandwidth, reduce complexity in interconnection and intercommunication between communication device and costs.

After the drawings and the detailed descriptions are read and understood, the other aspects can be comprehended.

### Brief Description of Drawings

FIG. 1 is a structure diagram of a transmission device according to the related technology.
FIG. 2 is a diagram of a signal flow direction of a transmission device according to the related technology.
FIG. 3 is a schematic diagram of an optical interconnection backboard according to embodiment one.
FIG. 4 is a schematic diagram of 45°mirror coupling according to embodiment one.
FIG. 5 is a schematic diagram of an MT connector according to embodiment one.
FIG. 6 is a connection diagram of service boards and an optical interconnection backboard in embodiment one.
FIG. 7 is a diagram of a signal flow direction of FIG. 6.
FIG. 8 is a structure diagram of an example according to embodiment one.
FIG. 9 is a flowchart of a signal scheduling method according to embodiment three.
FIG. 10 is a path diagram of example one.
FIG. 11 is a first path diagram of example two.
FIG. 12 is a second path diagram of example two.
FIG. 13 is a path diagram of example three.

### Detailed Description

Implementation modes of the present invention will be described below in combination with the drawings and embodiments.

It is important to note that the embodiments of the present invention and characteristics in the embodiments may be combined with each other without conflicts, and all fall within the scope of protection of the present application.

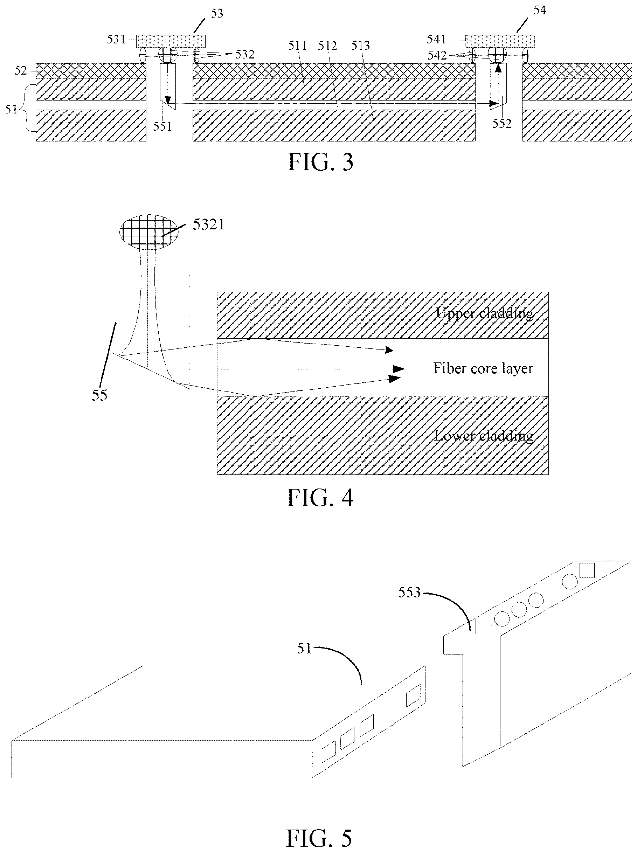

Embodiment one: an optical interconnection backboard, as shown in FIG. 3, includes:
an optical interconnection layer 51 including one or more optical waveguides;
a PCB 52;
a Transmitter Optical Subassembly (TOSA) 53 modulating electrical signals received from the PCB 52 into optical signals;
a Receiver Optical Subassembly (ROSA) 54 converting received optical signals into electrical signals and transmitting the electrical signals to the PCB 52;
a first waveguide coupling module 551 coupling the optical signals generated by the TOSA 53 into the optical interconnection layer 51;
a second waveguide coupling modules 552 coupling optical signals transmitted by the optical interconnection layer 51 into the ROSA 54; and
one or more Crossbars, configured to implement cross configuration from any path of input to any path of output, herein
each Crossbar is connected with at least one TOSA and one ROSA.

The optical interconnection backboard of the embodiment of the present invention may replace a backboard and cross boards, and thus may also be called as an optical interconnection cross backboard.

An optical signal has the advantages of high bandwidth, low loss, long transmission distance, no crosstalk, high anti-interference capability and the like, but it is difficult for scheduling in an optical layer, and an electrical layer has the characteristic of flexible scheduling. In the embodiment, the optical interconnection layer including the optical waveguides is added outside the PCB to form an Electro-Optical Printed Circuit Board (EOPCB) which can fully combine advantages of light and electricity and will be widely applied to new-generation microminiature, high-bandwidth, high-speed and high-capacity information device.

The EOPCB utilizes the advantages of high bandwidth, high density, no Electromagnetic Interference (EMI) and the like of light, thereby improving a transmission rate and security of data and reducing transmission noise, and has the characteristics of low loss and light weight, and in addition, cost of the PCB may be reduced. On the EOPCB, an optical transceiver device, for example, VCSELs and Positive-Intrinsic-Negative PhotoDiode (PIN-PD) detectors, is embedded into the EOPCB. The lasers generate optical signals for direct coupling to the optical waveguides as light sources, and then the detectors receive the optical signals coupled from the optical waveguides and recover electrical signals, to form paths.

In the embodiment, the electrical signals are transmitted in the PCB 52 through "electrical interconnection" of conventional copper lines, and the high-frequency optical signals are transmitted for a long distance through the optical interconnection layer 51.

An optical channel of the optical interconnection backboard of the embodiment is shown in FIG. 3. The optical signals transmitted by the TOSA 53 are coupled into the optical waveguide for propagation through the first waveguide coupling module 551, and at output end of the optical waveguide, the optical signals are coupled into the ROSA 54 through the second waveguide coupling module 552, and the optical signals are recovered into the electrical signals.

In an exemplary embodiment, the PCB 52 is a conventional multilayer PCB, and the optical interconnection layer 51 is arranged below or in middle of the conventional multilayer PCB, and the optical interconnection layer 51 is bonded together with the multilayer PCB.

The TOSA 53 and the ROSA 54 are arranged on a top layer of the multilayer PCB.

In an exemplary embodiment, the TOSA 53 includes a laser array 532 and a laser driving circuit chip 531; and the ROSA 54 includes a photoelectric detector array 542 and a detector driving circuit chip 541.

High-speed signal data streams are transmitted to the laser driving circuit chip through electrical lines of the PCB 52. The laser driving circuit chip 531 modulate lasers to emit light to modulate the high-speed signal data streams onto optical signals. The optical signals are coupled into the optical waveguide embedded into the PCB 52 through the first waveguide coupling module 551 for transmission. At the output end of the optical waveguide, the optical signals are coupled into the photoelectric detector through the second waveguide coupling module 552. The photoelectric detector restores the optical signals into electrical signals, and transmits them onto the detector driving circuit chip 541 connected with the photoelectric detector for transmission onto the PCB 52.

In the present document, a high-speed signal refers to a signal of which a rate is more than 1Gbps.

Herein, the lasers in the laser array 532 may be, but not limited to, VCSELs, and the photoelectric detectors in the photoelectric detector array 542 may be, but not limited to, PIN-PD detectors.

In an exemplary embodiment, the lasers in the laser array 532 and the photoelectric detectors in the photoelectric detector array 542 are welded together with the laser/detector driving circuit chip in a flip-chip bonding manner respectively, and in such a manner, light-emitting surfaces of the lasers and light-receiving surfaces of the photoelectric detectors face the optical interconnection layer 51.

In an exemplary embodiment, each laser/detector driving circuit chip drives m lasers/m photoelectric detectors, herein m is the number of the lasers included in the TOSA 53/the number of the photoelectric detectors included in the ROSA 54. m is an integer more than or equal to 1, and a value of m is determined by a model number of the TOSA 53/ROSA 54.

In an exemplary embodiment, the TOSAs 53 and the ROSAs 54 may be encapsulated on the PCB in a form, but not limited to, a Ball Grid Array (BGA) form.

In an exemplary embodiment, the optical interconnection layer 51 includes an upper cladding 511, a fiber core layer 512 and a lower cladding 513. The fiber core layer 512 includes one or more optical waveguides, and each optical waveguide is arranged in parallel. The optical waveguides are configured to transmit high-speed optical signals, and the number of the optical waveguides is determined by the amount of high-speed signals required to be transmitted by the optical interconnection backboard. For implementing optical communication, each optical waveguide is required to correspond to a laser, a photoelectric detector and a pair of waveguide coupling modules. A certain optical channel is shown in FIG. 3 only.

Correspondingly, when there are m lasers and m photoelectric detectors, the fiber core layer 512 may include m optical waveguides. Each of the first waveguide coupling module 551 and second waveguide coupling module 552 in FIG. 3 may include m waveguide couplers, to implement coupling of m paths of optical signals transmitted by the laser array 532 into the optical waveguides or coupling of the m paths of optical signals from the optical waveguides to the photoelectric detector array 542.

Herein, one end of each of the m waveguide couplers in the first waveguide coupling module 551 corresponds to a light-emitting interface of each of the m lasers, and the other end corresponds to an input end of each of the m optical waveguides. One end of each of the m waveguide couplers in the second waveguide coupling module 552 corresponds to a light-receiving interface of each of the m photoelectric detectors, and the other end corresponds to an output end of each of the m optical waveguides.

In the embodiment, a characteristic of coupling between the optical interconnection layer 51 and the TOSA 53/ROSA 54 is that a light in the optical interconnection layer 51 forms a 90° angle with a light emitted by the TOSA 53/light received by the ROSA 54. That is because a function of a waveguide coupling module is to implement 90°angle conversion of the light.

In an exemplary embodiment, the first and second waveguide coupling modules adopt 45° mirror coupling. The 45° mirror is irrelevant to a wavelength, and has a high coupling efficiency. A principle is shown in FIG. 4. Optical signals emitted by the laser 5321 are reflected into the fiber core layer through 45° mirror of the waveguide coupling module 55, so that light emitted by the laser 5321 forms the 90° angle with the light transmitted in the fiber core layer.

In an exemplary embodiment, the first and second waveguide coupling modules adopt MT connectors. An MT connector is a coupling manner often used for an optical fiber array at present, and it has the advantages of small size, accurate positioning, low insertion loss and the like. FIG. 5 is a schematic diagram of an MT connector 553, which is formed by 4 45°-end-face optical fiber arrays spaced by 250um and connected with the TOSA/ROSA respectively. The optical signals of the TOSA are reflected into the optical interconnection layer 51 through the 45° end face, or the optical signals of the optical interconnection layer 51 are reflected into the ROSA through the 45° end face, thereby implementing coupling of the TOSA/ROSA and the optical waveguide.

In an exemplary embodiment, there is one or more TOSAs 53 and ROSAs 54.

In the embodiment, the optical interconnection backboard further includes:
one or more backboard sockets, configured to provide high-speed electrical signal interfaces between service boards and the optical interconnection backboard.

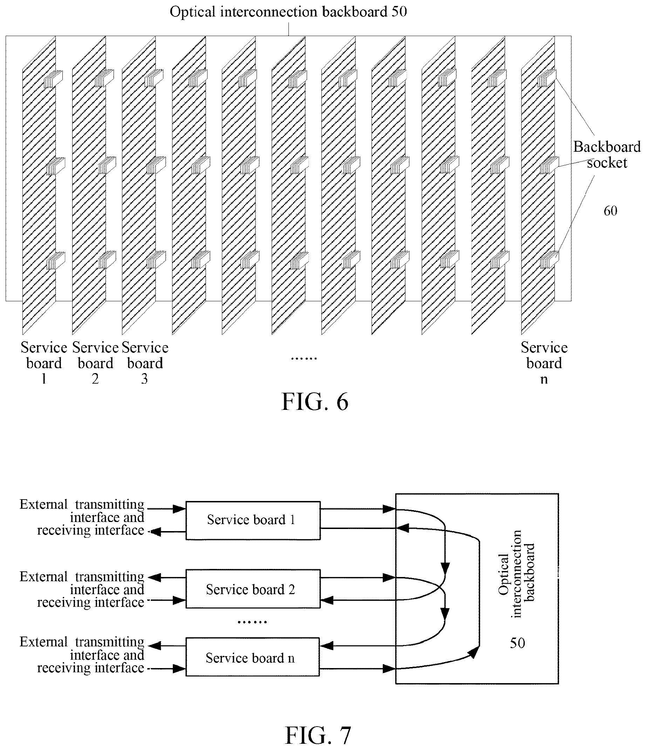

Herein, each backboard socket is connected with a Crossbar through the electrical lines of the PCB in the optical interconnection backboard in a one-to-one corresponding manner; and each Crossbar is connected with a service board through the corresponding backboard sockets in the one-to-one corresponding manner. For example, a service board 1∼service board n shown in FIG. 6 are all connected onto the optical interconnection backboard 50 through the backboard sockets 60.

In the optional solution, the service boards may be spliced to an upper surface of the optical interconnection backboard in rows, and cross scheduling between different service boards may be flexibly implemented. As shown in FIG. 7, each of the service board 1∼the service board n has external transmitting and receiving interfaces, and signals received by the service boards through the external receiving interfaces are transmitted to other service boards through the optical interconnection backboard 50, and then are transmitted out through the external transmitting interfaces.

In an exemplary embodiment, multiple rows of backboard sockets are welded on the top layer of the multilayer PCB, and are configured to provide high-speed electrical signal interfaces between P service boards and the optical interconnection backboard. P is an integer ≥ 3. Each row of the backboard sockets forward K pairs of high-speed electrical signals from communication device: Ti_1, Ti_2, ......., Ti_K; Ri_1, Ri_2, ......., Ri_K. Herein, K is an integer ≥1, 1 ≤ i ≤ P and i is the No. of the service board.

The Crossbar is configured to implement cross connection of K*(P+1)xK*(P+1) groups (when P is an even number) or cross connection of K*P×K*P groups (when P is an odd number), and may implement cross configuration from any path of input to any path of output.

In an exemplary embodiment, the Crossbar may also be configured to communicate with a central CU through the electrical lines of the multilayer PCB to implement cross scheduling between different electrical transmitting and receiving interfaces.

In an exemplary embodiment, the number of TOSAs, the number of ROSAs, the number of first waveguide coupling modules and the number of second waveguide coupling modules are all (P-1)×2. The TOSAs are connected with the first waveguide coupling modules in the one-to-one corresponding manner, and the ROSAs are connected with the second waveguide coupling modules in the one-to-one corresponding manner. There are P Crossbars connected with the service boards in the one-to-one corresponding manner. P is the number of the service boards.

Each Crossbar is sequentially connected. Each of the first and last Crossbars is connected with a TOSA and a ROSA. Each of other Crossbars is connected with a TOSA and ROSA for transmission in a first direction, and is connected with a TOSA and ROSA for transmission in a second direction.

The first Crossbar is connected with the ROSA, connected with the next Crossbar, for transmission in the first direction through the connected TOSA, and is connected with the TOSA, connected with the next Crossbar, for transmission in the second direction through the connected ROSA.

The last Crossbar is connected with the TOSA, connected with the previous Crossbar, for transmission in the first direction through the connected ROSA, and is connected with the ROSA, connected with the previous Crossbar, for transmission in the second direction through the connected TOSA.

For any other two adjacent Crossbars, one Crossbar is connected with the ROSA, connected with the other Crossbar, for transmission in the first direction through the connected TOSA for transmission in the first direction, and is connected with the TOSA, connected with the other Crossbar, for transmission in the second direction through the connected ROSA for transmission in the second direction.

Herein, that the TOSA is connected with the ROSA means that the TOSA is connected to the second waveguide coupling module correspondingly connected with the ROSA through the correspondingly connected first waveguide coupling module and the optical interconnection layer.

When P is an even number, each Crossbar has (P+1)*K pairs of electrical transmitting and receiving interfaces, identified as:
Ti_1/Ri_1, Ti_2/Ri_2, ......, Ti_K/Ri_K, totally K pairs,
Ti_R1/Ri_R1, Ti_R2/Ri_R2, ......, totally P*K/2 pairs, and
Ti_L1/Ri_L1, Ti_L2/Ri_L2, ......, totally P*K/2 pairs.

The (P+1)*K pairs of electrical transmitting and receiving interfaces include K pairs of electrical transmitting and receiving interfaces for connecting the backboard sockets, P*K electrical transmitting and receiving interfaces for connecting the TOSA and P*K electrical transmitting and receiving interfaces for connecting the ROSA.

Correspondingly, each TOSA/ROSA includes P*K/2 lasers/photoelectric detectors.

If P is an odd number, 1 is subtracted from P for calculation, that is, each Crossbar has K*P pairs of electrical transmitting and receiving interfaces, identified as:
Ti_1/Ri_1, Ti_2/Ri_2, ......, Ti_K/Ri_K, totally K pairs,
Ti_R1/Ri_R1, Ti_R2/Ri_R2, ......, totally (P-1)*K pairs, and
Ti_L1/Ri_L1, Ti_L2/Ri_L2, ......, totally (P-1)*K pairs.

The K*P pairs of electrical transmitting and receiving interfaces include K pairs of electrical transmitting and receiving interfaces for connecting the backboard sockets, (P-1)*K electrical transmitting and receiving interfaces for connecting the TOSA and (P-1)*K electrical transmitting and receiving interfaces for connecting the ROSA.

Correspondingly, each TOSA/ROSA includes (P-1)*K/2 lasers/photoelectric detectors.

Herein, the electrical transmitting and receiving interfaces Ti_1/Ri_1, Ti_2/Ri_2, ......., Ti_K/Ri_K are connected with the backboard sockets, and receive K high-speed electrical signals from the service boards, or transmit K high-speed electrical signals to the service boards. Ti_R1, Ti_R2, ...... are connected with the TOSA at right side of the Crossbar; and Ri_R1, Ri_R2, ...... are connected with the ROSA at right side of the Crossbar. Ti_L1, Ti_L2, ...... are connected with the TOSA at the left side of the Crossbar; and Ri_L1, Ri_L2, ...... are connected with the ROSA at the left side of the Crossbar.

Each TOSA includes a laser array and a laser driving circuit chip. The ROSA includes a photoelectric detector array and a detector driving circuit chip. The lasers and the photoelectric detectors are welded together with the corresponding driving circuit chip in the flip-chip bonding manner, and in such a manner, the light-emitting surfaces of the lasers and the light-receiving surfaces of the photoelectric detectors face the optical interconnection layer. Each driving circuit chip may drive P*K/2 lasers or P*K/2 photoelectric detectors, herein P is an even number, and K is an integer more than or equal to 1. Or each driving circuit chip may drive (P-1)*K/2 lasers or (P-1)*K/2 photoelectric detectors, herein P is an odd number, and K is an integer more than or equal to 1. The TOSAs and the ROSAs are encapsulated on the circuit board in the BGA form.

The optical signals generated by the TOSA at the right side of the Crossbar are coupled into the optical interconnection layer through the waveguide coupling module for transmission, and then the optical signals are coupled to the ROSA at the left side of the Crossbar in its downstream through the waveguide coupling module. The ROSA at the right side of the Crossbar receives the optical signals transmitted by the TOSA at the left side of the Crossbar in its downstream from the optical interconnection layer through the waveguide coupling module.

Similarly, the optical signals generated by the TOSA at the left side of the Crossbar are coupled into the optical interconnection layer through the waveguide coupling module for transmission, and then the optical signals are coupled to the ROSA at the right side of the Crossbar on its upstream through the waveguide coupling module. The ROSA at the left side of the Crossbar receives the optical signals transmitted by the TOSA at the right side of the Crossbar on its upstream from the optical interconnection layer through the waveguide coupling module.

The waveguide coupling module is an array formed by P*K/2 (P is an even number) or (P-1)*K/2 (P is an odd number) waveguide couplers, and implements coupling of P*K/2 (P is an even number) or (P-1)*K/2 (P is an odd number) paths of optical signals transmitted by the laser array into P*K/2 (P is an even number) or (P-1)*K/2 (P is an odd number) optical waveguides in the optical interconnection layer or coupling of P*K/2 (P is an even number) or (P-1)*K/2 (P is an odd number) paths of optical signals from the optical waveguides to the photoelectric detector array.

In the embodiment of the invention, a characteristic of coupling between the optical interconnection layer and the optical transmission/receiving module is that the light in the optical interconnection layer forms the 90° angle with light in the optical transmission/receiving module, so the waveguide coupling module implements 90°-angle changes of the light. Via holes are predesigned in the multilayer PCB of the optical interconnection backboard, so that the waveguide coupling module may penetrate through the multilayer PCB to be bonded together with the optical interconnection layer. One surface of each of the waveguide coupling modules is strictly aligned with the P*K/2 (P is an even number) or (P-1)*K/2 (P is an odd number) optical waveguides in the optical interconnection layer, so that lights may enter the optical waveguides from the waveguide coupling modules for transmission, or enter the waveguide coupling modules from the optical waveguides. The other surface of each of the waveguide coupling modules is strictly aligned with the light-emitting surface of the laser array or the light-receiving surface of the photoelectric detector array, to ensure that multiple waveguide couplers correspond to light-emitting interfaces of multiple lasers or light-receiving interfaces of multiple photoelectric detectors one to one.

In the optional solution, the electrical signals are transmitted through "electrical interconnection" of the conventional copper lines, and the high-frequency optical signals are transmitted for a long distance through the optical interconnection layer.

High-speed signal data streams from the service boards are received by the backboard sockets, and are transmitted to certain electrical receiving interface of the Crossbar through short-distance electrical lines of the multilayer PCB. Then the central CU controls the Crossbar to implement cross scheduling between the high-speed signal data streams of the electrical receiving interface to any path of electrical transmission interface, and then transmit them to the laser driving circuit chip. The laser driving circuit chip modulates the lasers to emit lights to modulate the high-speed signal data streams onto optical signals. The optical signals are coupled into the optical waveguide embedded into the PCB through the waveguide coupling module for transmission. At the output ends of the optical waveguide, the optical signals are coupled into the downstream photoelectric detectors through the waveguide coupling module. The photoelectric detectors restore the optical signals into electrical signals, and finally transmit them onto the detector driving circuit chip connected with the photoelectric detectors. The detector driving circuit chip is connected with the downstream Crossbar. Similarly, the central CU controls the Crossbar to implement cross scheduling between the high-speed signal data streams of the electrical receiving interface to any path of electrical receiving interface and then transmit the high-speed signal data streams to the downstream backboard sockets and further to the service board connected with the backboard sockets.

And vice versa.

It is summarized that a signal flow direction in the optional solution is: input signals (high-speed signal data streams)--backboard sockets-the Crossbar--the TOSA-the waveguide coupling module--the built-in optical waveguide--the waveguide coupling module--the ROSA--the Crossbar--backboard sockets--output signals (high-speed signal data streams).

In the optional solution, a cross capacity of the optical interconnection backboard is P*K*rate of signals transmitted by each path of optical channels.

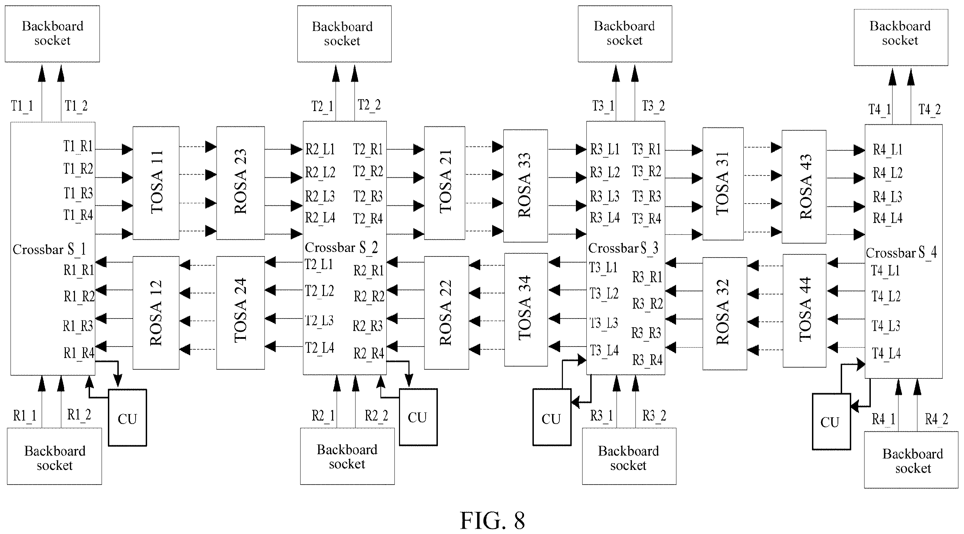

In a practical example of the optional solution, K=2, P=4, and a network structure diagram of the example is shown in FIG. 8. An optical interconnection backboard includes:
a multilayer PCB;
TOSAs 11, 21, 31, 24, 34 and 44; and
ROSAs 12, 22, 32, 23, 33 and 43.

Herein, optical signals are transmitted between the TOSAs and the ROSAs through an optical interconnection layer and a pair of waveguide coupling modules.

4 backboard sockets are further welded on a top layer of the multilayer PCB, and each backboard socket is connected with Crossbars S_1∼S_4 and 4 service boards through electrical lines of the multilayer PCB in a one-to-one corresponding manner respectively.

A TOSA and a ROSA are arranged at right sides of the Crossbars S_1∼S_3; and a TOSA and a ROSA are arranged at left sides of the Crossbars S_2∼S_4.

The Crossbar S_i has K*(P+1), i.e., 10 pairs of electrical transmitting and receiving interfaces, identified as:
Ti_1/Ri_1 and Ti_2/Ri_2; Ti_1/Ri_1, Ti_2/Ri_2, Ti_3/Ri_3 and Ti_4/Ri_4; and Ti_L1/Ri_L1, Ti_L2/Ri_L2, Ti_L3/Ri_L3 and Ti_L3/Ri_L4. Herein, the electrical transmitting and receiving interfaces Ti_1/Ri_1 and Ti_2/Ri_2 are connected with the backboard sockets, and receive 2 high-speed electrical signals from the service boards, or transmit 2 high-speed electrical signals to the service boards. Ti_1/Ri_1, Ti_2/Ri_2, Ti_3/Ri_3 and Ti_4/Ri_4 are connected with the optical transmission/receiving modules at the right sides; and Ti_L1/Ri_L1, Ti_L2/Ri_L2, Ti_L3/Ri_L3 and Ti_L3/Ri_L4 are connected with the optical transmission/receiving modules at the left sides. In FIG. 8, there are no other Crossbars connected to the left side of the Crossbar S_1 and the right side of the Crossbar S_4, and thus the corresponding electrical transmitting and receiving interfaces are not shown in FIG. 8.

In the example, the TOSA adopts the VCSEL transmission module, integrates 4 paths of VCSELs and laser driving circuit chips, and has 4 independent VCSEL pixels, and may convert electrical signals into optical signals. The ROSA adopts the PIN-PD receiving module, integrates 4 paths of PIN-PD detectors and detector driving circuit chips, and has 4 independent PIN-PD pixels, and may convert optical signals into electrical signals. The waveguide coupling modules of the example are MT connectors.

Each service board is connected with a Crossbar through a backboard socket in the one-to-one corresponding manner, and then the Crossbar communicates with the outside through the corresponding optical transmission or ROSA, and an optical-waveguide-based optical interconnection technology is adopted between the Crossbars. Data connection of input/output data transmitted to the backboard by each service board in each direction is implemented, then the data are converted into optical signals through the VCSELs, and light is introduced into optical waveguides arranged in the circuit board for transmission through waveguide couplers. At the next Crossbar, the PIN-PD photoelectric detectors reconvert optical signals into electrical signals for the Crossbar to distribute and finally transmit to the target service board through the backboard sockets. In the system, implementation of cross scheduling between each service board requires multiple electrical switching and optical transmission, so that the problems of crosstalk, interference and the like in a transmission process are substantially solved, and a communication rate is greatly increased.

The optical interconnection backboard of the example is formed by bonding the optical interconnection layer and the multilayer PCB, and the optical interconnection layer may be located in middle of or below the multilayer PCB. The optical interconnection layer is formed by an upper cladding, a lower cladding and a fiber core layer, and 8 optical waveguides are laid in the fiber core layer.

For improving optical signal coupling efficiency, the optical waveguides in the fiber core layer of the example adopt multimode optical fibers, and that is because fiber cores of the multimode optical fibers have relatively large areas. The 8 optical waveguides of the optical interconnection layer of the example are arranged into a one-dimensional array at a spacing of 250um with an error within 0.5um.

Via holes are predesigned in the multilayer PCB of the optical interconnection backboard of the example, so that the MT connectors may penetrate through the multilayer PCB to be bonded together with the optical interconnection layer. Optical signals of the example are transmitted in two directions, and 4 optical waveguides are arranged in each direction. Two MT connectors are arranged at the left and right sides of each Crossbar respectively. One surface of one MT connector at a certain side is strictly aligned with 4 optical waveguides in the optical interconnection layer, so that the light may enter the optical waveguides from the MT connector for transmission. The other surface is strictly aligned with a light-emitting surface of the VCSEL array, to ensure that 4 optical fibers in the MT connector are aligned with light-receiving interfaces of 4 lasers in the one-to-one corresponding manner. One surface of the other MT connector at the certain side of the Crossbar is strictly aligned with other 4 optical waveguides in the optical interconnection layer, so that optical signals may enter the MT connector from the optical waveguides. The other surface of the MT connector is strictly aligned with a light-receiving surface of the PIN-PD array, to ensure that in the 8 MT connectors 4 optical fibers are aligned with light-receiving interfaces of 4 PIN-PD detectors in the one-to-one corresponding manner.

The Crossbar of the example adopt the VSC3321 chip, and has totally 24 input/output ports, herein 8 ports are used for input, 8 ports are used for output, and the other 8 ports may be freely configured as input/output interfaces. The Crossbar may be configured into 12x12 cross connection, and may also be configured into an 8x16 or 16x8 cross multiplexing form. In the example, they are configured into 10x10 cross connection, and the other 4 pins are idle.

According to the optical interconnection backboard of the example, if the rate of the signal transmitted by each path of optical channels is 25Gbit/s, the cross capacity of the optical interconnection backboard is 4*2%25Gbit/s=200Gbit/s.

Embodiment two: a transmission device includes the optical interconnection backboard of embodiment one and one or more service boards.

Crossbars in the optical interconnection backboard are connected with the service boards in a one-to-one corresponding manner.

In an exemplary embodiment, the optical interconnection backboard further includes one or more backboard sockets, and one backboard socket is connected with one service board.

Each service board further includes backboard sockets; and each service board is mated with backboard sockets on the backboard through own backboard sockets, and is mounted on the optical interconnection backboard.

Electrical transmitting and receiving interfaces for connecting the service boards in the Crossbars are connected to the backboard sockets on the optical interconnection backboard, to be connected with the service boards mounted on the optical interconnection boards.

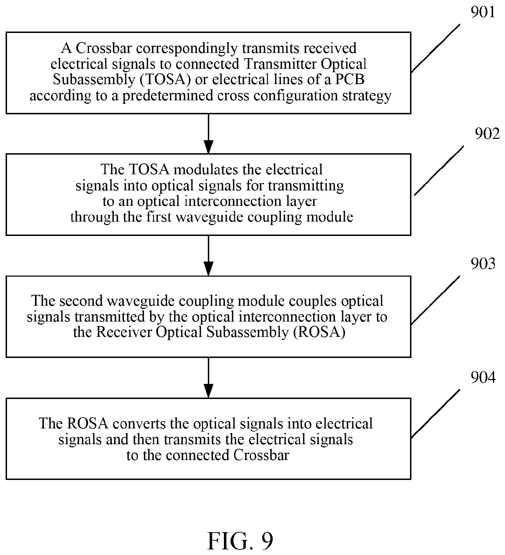

Embodiment three: as shown in FIG. 9, a signal scheduling method based on the optical interconnection board of embodiment one is adopted to implement cross scheduling between service boards, and includes the following steps.

In Step 901, a Crossbar correspondingly transmits received electrical signals to connected TOSA or electrical lines of a PCB according to a predetermined cross configuration strategy.

In Step 902, the TOSA modulates the electrical signals into optical signals and then transmits to an optical interconnection layer through the first waveguide coupling module.

In Step 903, the second waveguide coupling module couples optical signals transmitted by the optical interconnection layer to the ROSA.

In Step 904, the ROSA converts the optical signals into electrical signals and then transmits the electrical signals to the connected Crossbar.

Herein, the predetermined cross configuration strategy may be transmitted to the Crossbar by a central CU, and may also be preset in the Crossbar.

In an exemplary embodiment, the electrical signals received by the Crossbar include:
electrical signals received through the electrical lines of the PCB, and electrical signals received through the connected ROSAs.

In an exemplary embodiment, the operation that the Crossbar correspondingly transmits the received electrical signals to the connected TOSA or the electrical lines of the PCB according to the predetermined cross configuration strategy includes that:
different electrical transmitting and receiving interfaces of the Crossbar are connected with the electrical lines of the PCB and the TOSAs respectively; and
the Crossbar transmits the received electrical signals to the corresponding electrical transmitting and receiving interfaces according to the predetermined cross configuration strategy.

The signal scheduling method in different scenarios will be described below with three implementation examples respectively.

Implementation example one, scenario one: self-cross of service board

A service board E_i performs self-cross on an optical interconnection backboard. 1≤i≤P, and i is the No. of the service board and a structure of the optical interconnection backboard is the same as the example shown in FIG. 8. A signal circuit process in the implementation example includes the following steps.

In 101, the service board E_i receives service signals through an external receiving interface, and converts it into K high-speed electrical signals to a backboard socket B_i by own service conversion.

In 102, the backboard socket B_i transmits the K high-speed electrical signals to a Crossbar S_i through electrical lines of a multilayer PCB.

In 103, a central CU controls the Crossbar S_i to connect its electrical transmission interfaces Ti_1, Ti_2, ......., Ti_K with its electrical receiving interfaces Ri_1, Ri_2, ......., Ri_K one to one.

In 104, the electrical transmission interfaces Ti_1, Ti_2, ......, Ti_K of the Crossbar S_i transmit the K high-speed electrical signals back to the backboard socket B_i through the electrical lines of the multilayer PCB.

In 105, the K high-speed electrical signals are received by the service board E_i from the backboard, and a service is transmitted out from external transmitting interfaces by service conversion.

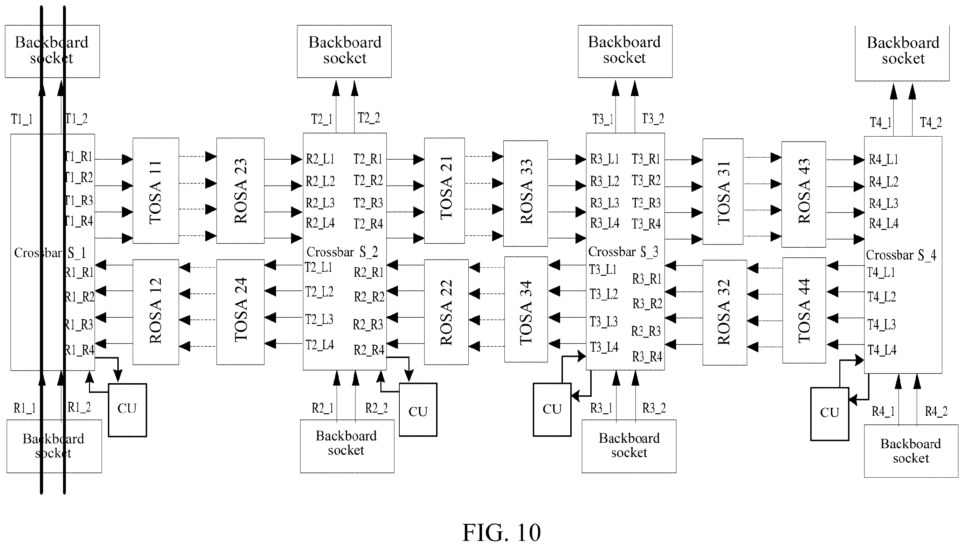

When i=2 and K=2, transmission paths of the high-speed electrical signals are shown in FIG. 10. The two paths are from an electrical receiving interface R1_1 to electrical transmission interface T1_1 of the Crossbar S_1, and from an electrical receiving interface R1_2 to electrical transmission interface T1_2 of the Crossbar S_1 respectively.

Note: self-cross of the service board does not pass the optical interconnection layer of the optical interconnection backboard.

Implementation example two, scenario two: cross scheduling between adjacent service boards

Cross scheduling is performed between service boards E_i and E_i+1 or between service boards E_i and E_i-1 on an optical interconnection backboard. 1 ≤ i,i+1,i-1 ≤ P. In the implementation example, it is defined that the service board E_i+1 is a downstream of the service board E_i and the service board E_i-1 is upstream of the service board E_i.

Descriptions will be made with scheduling of an xth path of high-speed electrical signal of the service board E_i to a yth path of its downstream service board E_i+1 as an example. Herein, 1 ≤ x, y ≤ K, and x may be equal to y, and may also be unequal to y. A structure of the optical interconnection backboard is the same as the example shown in FIG. 8. A signal circuit process in the implementation example includes the following steps.

In 201, the service board E_i receives service signals through an external receiving interface, and converts it into K high-speed electrical signals to a backboard socket B_i by own service conversion.

In 202, the backboard socket B_i transmits the K high-speed electrical signals to a Crossbar S_i through electrical lines of the multilayer PCB.

In 203, a central CU controls the Crossbar S_i to connect its electrical transmission interface Ti_Ry with its electrical receiving interface Ri_x, that is, Ti_Ry=Ri_x.

In 204, Ti_Ry of the Crossbar S_i is connected with a laser driving circuit chip of a TOSA at its right side through an electrical line of the PCB, and the laser driving circuit chip modulates the xth path of high-speed electrical signal transmitted to the backboard by the service board E_i onto optical signals by making a yth laser of a laser light-emitting array emit light, and the optical signals are coupled into an optical waveguide in the PCB through a waveguide coupling module for transmission.

In 205, at an output end of the optical waveguide, the optical signals are coupled to a yth photoelectric detector in a photoelectric detector array at a left side of a downstream Crossbar S_i+1 through the waveguide coupling module, and the photoelectric detector restores the optical signals into electrical signals, and finally transmits the electrical signals to a detector driving circuit chip connected with the photoelectric detector, and then is connected with an electrical receiving interface Ri+1_Ly of the Crossbar S_i+1.

In 206, the central CU controls the Crossbar S_i+1 to connect its electrical transmission interface Ti+1_y with its electrical receiving interface Ri+1_Ly, that is, Ti+1_y=Ri+1_Ly.

In 207, the service board E_i+1 receives the high-speed electrical signals from the electrical transmission interface Ti+i_y of the Crossbar S_i+1 through a backboard socket B_i+1, to implement cross scheduling of the high-speed electrical signals.

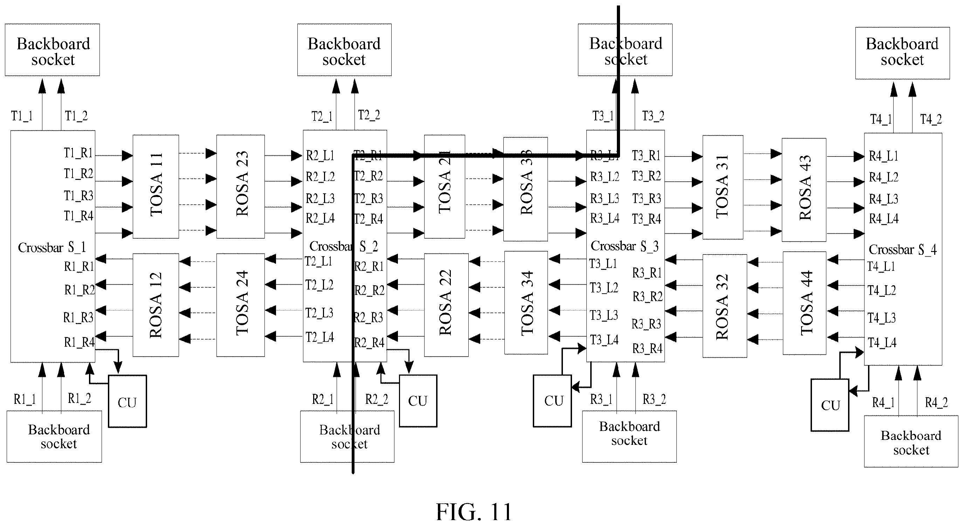

When i=2, K=2, x=2 and y=1, a transmission path of the high-speed electrical signals is, as shown in FIG. 11, from an electrical receiving interface R2_2 of the Crossbar S_2 to an electrical transmission interface T3_1 of the Crossbar S_3.

Descriptions will be made with scheduling of the xth path of high-speed electrical signal of the service board E_i to a yth path of its upstream service board E_i-1 as an example. Herein, 1 ≤ x, y ≤ K, and x may be equal to y, and may also be unequal to y. The structure of the optical interconnection backboard is the same as the example shown in FIG. 8. A signal circuit process in the implementation example includes the following steps.

In 301, the service board E_i receives a service through the external receiving interface, and converts it into K high-speed electrical signals to the backboard socket B_i by own service conversion.

In 302, the backboard socket B_i transmits the K high-speed electrical signals to the Crossbar S_i through the electrical lines of the multilayer PCB.

In 303, the central CU controls the Crossbar S_i to connect its electrical transmission interface Ti_Ly with its electrical receiving interface Ri_x, that is, Ti_Ly=Ri_x.

In 304, Ti_Ly of the Crossbar S_i is connected with a laser driving circuit chip of a TOSA at its left side through an electrical line of the PCB, and the laser driving circuit chip modulates the xth path of high-speed electrical signal transmitted to the backboard by the service board E_i onto optical signals by making a yth laser of a laser light-emitting array emit light, and the optical signals are coupled into an optical waveguide in the PCB through a waveguide coupling module for transmission.

In 305, at an output end of the optical waveguide, the optical signals are coupled to a yth photoelectric detector in a photoelectric detector array at a right side of an upstream Crossbar S_i-1 through the waveguide coupling module, and the photoelectric detector restores the optical signals into electrical signals, and finally transmits the electrical signals to a detector driving circuit chip connected with the photoelectric detector, and then is connected with an electrical receiving interface Ri-1_Ry of the Crossbar S_i-1.

In 306, the central CU controls the Crossbar S_i+1 to connect its electrical transmission interface Ti+1_y with its electrical receiving interface Ri-1_Ry, that is, Ti-1_y=Ri-1_Ry.

In 307, the service board E_i-1 receives the high-speed electrical signals from the electrical transmission interface Ti-i_y of the Crossbar S_i-1 through a backboard socket B_i-1, to implement cross scheduling of the high-speed electrical signals.

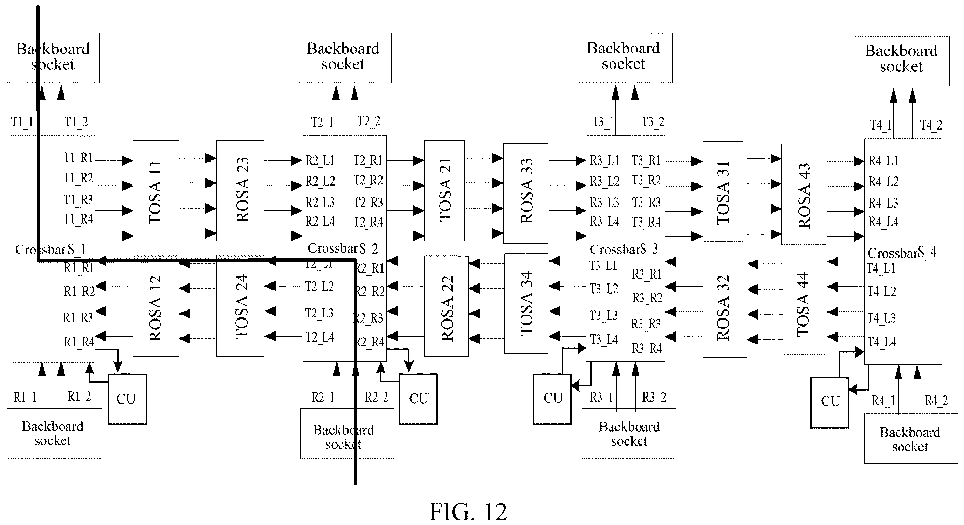

When i=1, K=2, x=2 and y=1, a transmission path of the high-speed electrical signals is, as shown in FIG. 12, from an electrical receiving interface R2_2 of the Crossbar S_2 to an electrical transmission interface T1_1 of the Crossbar S_1.

Note: cross scheduling is performed on the service boards and upstream or downstream service boards through different electrical transmitting and receiving interfaces of the Crossbars. Cross scheduling with the downstream service board is implemented through the electrical transmitting and receiving interfaces Ti_R1/Ri_R1, Ti_R2/Ri_R2, ......; and cross scheduling with the upstream service board is implemented through the electrical transmitting and receiving interfaces Ti_L1/Ri_L1, Ti_L2/Ri_L2, .......

Implementation example three, scenario three: cross scheduling between nonadjacent service boards

A backboard socket, a Crossbar connected therewith and optical transmission/receiving module at left and right sides of the Crossbar are defined as a node. Cross scheduling between nonadjacent service boards is substantially consistent with cross scheduling between adjacent service boards. However, at an intermediate node, cross scheduling with electrical transmitting and receiving interfaces connected with optical transmission/receiving module in a Crossbar is controlled by a central CU not passing the transmitting and receiving interfaces Ti_1/Ri_1, Ti_2/Ri_2, ......, Ti_K/Ri_K connected with the backboard sockets. Descriptions will be made with cross scheduling of an xth path of high-speed electrical signal transmitted to a backboard by a service board E_i and a yth path of a service board E_i+2 as an example. A structure of an optical interconnection backboard is the same as the example shown in FIG. 8. A signal circuit process in the implementation example includes the following steps.

In 401, the service board E_i receives a service through an external receiving interface, and converts it into K high-speed electrical signals to a backboard socket B_i by own service conversion.

In 402, the backboard socket B_i transmits the K high-speed electrical signals to a Crossbar S_i through an electrical line of the multilayer PCB.

In 403, the central CU controls the Crossbar S_i to connect its electrical transmission interface Ti_Ry with its electrical receiving interface Ri_x, that is, Ti_Ry=Ri_x.

In 404, Ti_Ry of the Crossbar S_i is connected with a laser driving circuit chip of a TOSA at its right side through an electrical line of the PCB, and the laser driving circuit chip modulates the xth path of high-speed electrical signal transmitted to the backboard by the service board E_i onto optical signals by making a yth laser of a laser light-emitting array emit light, and the optical signals are coupled into an optical waveguide in the PCB through a waveguide coupling module for transmission.

In 405, at an output end of the optical waveguide, the optical signals are coupled to a yth photoelectric detector in a photoelectric detector array at a left side of a downstream Crossbar S_i+1 through the waveguide coupling module, and the photoelectric detector restores the optical signals into electrical signals, and finally transmits the electrical signals to the detector driving circuit chip connected with the photoelectric detector, and then is connected with an electrical receiving interface Ri+1_Ly of a Crossbar S_i+1.

In 406, the central CU controls the Crossbar S_i+1 to connect its electrical transmission interface Ti+1_Ry with its electrical receiving interface Ri+1_Ly, that is, Ti+1_Ry=Ri+1_Ly.

In 407, Ti_Ry of the Crossbar S_i+1 is connected with a TOSA at its right side, performs conversion to obtain optical signals and couples the optical signals into the optical waveguide through the waveguide coupling module for transmission.

In 408, a ROSA at the left side of the downstream Crossbar S_i+2 receives the optical signals, restores the optical signals into electrical signals, and then is connected with an electrical receiving interface Ri+2_Ly of the Crossbar S i+2.

In 409, the central CU controls the Crossbar S_i+2 to connect its electrical transmission interface Ti+2_y with its electrical receiving interface Ri+2_Ly, that is, Ti+2_y=Ri+2_Ly.

In 410, the service board E_i+2 receives the high-speed electrical signals from the electrical transmission interface Ti+2_y of the Crossbar S_i+2 through a backboard socket B_i+2, to implement cross scheduling of the high-speed electrical signals.

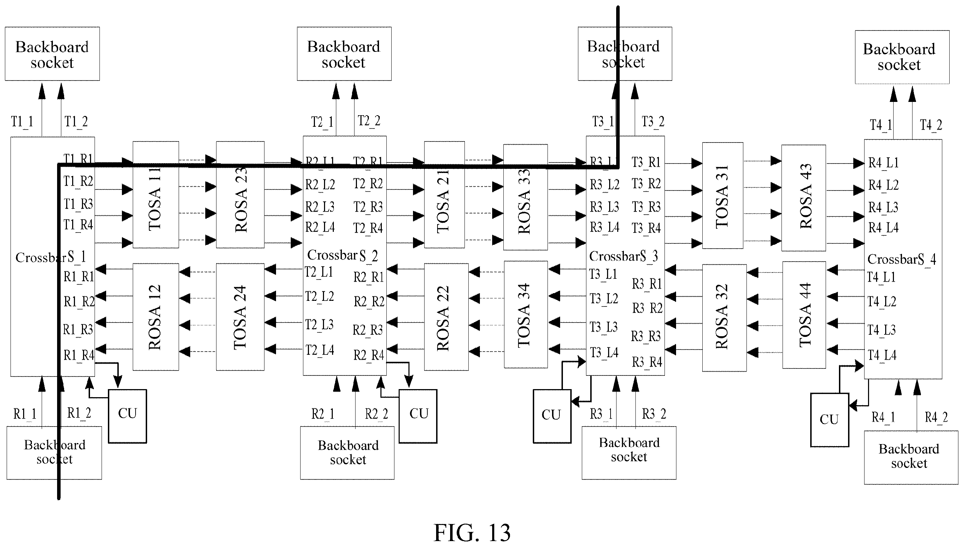

When i=1, K=2, x=2 and y=1, a transmission path of the high-speed electrical signals is, as shown in FIG. 13, from an electrical receiving interface R1_2 of the Crossbar S_1 to an electrical transmission interface T3_1 of the Crossbar S_3.

The abovementioned three scenarios are typical cross scheduling scenarios of the optical interconnection backboard, but the scenarios are no limited to the abovementioned scenarios, and a user may implement flexible scheduling according to a requirement. It is important to note that a basic unit for scheduling is not the service board but each path of high-speed electrical signals transmitted to the backboard by the service board.

In addition, cross scheduling links in the abovementioned three scenarios are not unique, and the user may implement flexible scheduling according to a practical condition as long as there are no conflicts between each signal transmitted to the backboard.

An embodiment of the present invention further provides a computer-readable storage medium, which stores a computer-executable instruction. The computer-executable instruction is executed by a processor to implement the abovementioned signal scheduling method.

Although the implementation modes disclosed by the present invention is mentioned above, the contents are only implementation modes adopted to facilitate understanding to the present invention and not intended to limit the present application. Those skilled in the art may make any modifications and variations to implementation forms and details without departing from the essence and scope disclosed by the present application. However, the scope of patent protection of the present application is still required to be subject to the scope defined by the appended claims.

### Industrial Applicability

The embodiments of the present invention combine advantages of optical transmission and electrical transmission, fully utilize the advantages of high optical transmission rate, low loss, long transmission distance, high anti-interference performance and the like and flexible scheduling in an electrical layer, and integrate cross boards and backboard of conventional transmission device. The embodiments of the present invention solve a bottleneck of limit to a cross capacity of the conventional device, effectively increase the cross capability of the transmission device and a single-channel bandwidth, reduce complexity in interconnection and intercommunication between communication device and costs.

## Claims

1. An optical interconnection backboard, comprising: a Printed Circuit Board, PCB;
and the optical interconnection backboard further comprising:
an optical interconnection layer comprising one or more optical waveguides;
a Transmitter Optical Subassembly, TOSA, configured to modulate an electrical signal received from the PCB into an optical signal;
a Receiver Optical Subassembly, ROSA, configured to convert a received optical signal into an electrical signal and transmit the electrical signal to the PCB;
a first waveguide coupling module, configured to couple the optical signal generated by the TOSA into the optical interconnection layer;
a second waveguide coupling module, configured to couple the optical signal transmitted by the optical interconnection layer into the ROSA; and
one or more Crossbars, configured to implement cross configuration from any path of inputs to any path of outputs, wherein
each Crossbar is connected with at least one TOSA and one ROSA.

2. The optical interconnection backboard according to claim 1, wherein
the TOSA comprises a laser array and a laser driving circuit chip; and the ROSA comprises a photoelectric detector array and a detector driving circuit chip.

3. The optical interconnection backboard according to claim 2, wherein
lasers in the laser array are Vertical Cavity Surface Emitting Lasers, VCSELs, and photoelectric detectors in the photoelectric detector array are Positive-Intrinsic-Negative, PIN, photoelectric detectors.

4. The optical interconnection backboard according to claim 2, wherein
the lasers in the laser array are welded together with the laser driving circuit chip in a flip-chip bonding manner, and the photoelectric detectors in the photoelectric detector array are welded together with the detector driving circuit chip in the flip-chip bonding manner, and light-emitting surfaces of the lasers and light-receiving surfaces of the photoelectric detectors face the optical interconnection layer.

5. The optical interconnection backboard according to claim 3, wherein
the optical interconnection layer comprises an upper cladding, a fiber core layer and a lower cladding; and the fiber core layer comprises one or more optical waveguides, and each optical waveguide is arranged in parallel.

6. The optical interconnection backboard according to claim 5, wherein
the laser array comprises m lasers; the photoelectric detector array comprises m photoelectric detectors, the fiber core layer comprises m optical waveguides, and the first waveguide coupling module and the second waveguide coupling module comprise m waveguide couplers respectively; m being an integer more than or equal to 1;
one end of each of the m waveguide couplers in the first waveguide coupling module corresponds to a light-emitting interface of each of the m lasers, and the other end corresponds to an input end of each of the m optical waveguides; and
one end of each of the m waveguide couplers in the second waveguide coupling module corresponds to a light-receiving interface of each of the m photoelectric detectors, and the other end corresponds to an output end of each of the m optical waveguides.

7. The optical interconnection backboard according to claim 1, wherein
the PCB is a multilayer PCB, and the optical interconnection layer is arranged below or in middle of the multilayer PCB, and the optical interconnection layer is bonded together with the multilayer PCB; and
the TOSA and the ROSA are arranged on a top layer of the multilayer PCB.

8. The optical interconnection backboard according to claim 1, wherein
a light in the optical interconnection layer forms a 90°angle with a light emitted by the TOSA and forms a 90°angle with a light received by the ROSA.

9. The optical interconnection backboard according to claim 1, further comprising:
one or more backboard sockets, configured to provide a high-speed electrical signal interface between a service board and the optical interconnection backboard, wherein
each backboard socket is connected with a Crossbar through electrical lines of the PCB in a one-to-one corresponding manner; and
each Crossbar is connected with a service board through the corresponding backboard socket in the one-to-one corresponding manner.

10. The optical interconnection backboard according to any one of claims 1-9, wherein
a number of TOSAs, a number of ROSAs, a number of first waveguide coupling modules and a number of second waveguide coupling modules are all (P-1)×2, and the TOSAs are connected with the first waveguide coupling modules in the one-to-one corresponding manner, and the ROSAs are connected with the second waveguide coupling modules in the one-to-one corresponding manner; and there are P Crossbars connected with service boards in the one-to-one corresponding manner; and P being a number of the service boards;
each Crossbar is sequentially connected; each of the first and last Crossbars is connected with a TOSA and a ROSA; each of other Crossbars is connected with a TOSA and ROSA for transmission in a first direction, and connected with a TOSA and ROSA for transmission in a second direction;
the first Crossbar is connected with the ROSA, connected with a next Crossbar, for transmission in the first direction through the connected TOSA, and is connected with the TOSA, connected with the next Crossbar, for transmission in the second direction through the connected ROSA;
the last Crossbar is connected with the TOSA, connected with a previous Crossbar, for transmission in the first direction through the connected ROSA, and is connected with the ROSA, connected with the previous Crossbar, for transmission in the second direction through the connected TOSA; and
for any other two adjacent Crossbars, one Crossbar is connected with the ROSA, connected with the other Crossbar, for transmission in the first direction through the connected TOSA for transmission in the first direction, and is connected with the TOSA, connected with the other Crossbar, for transmission in the second direction through the connected ROSA for transmission in the second direction;
wherein that the TOSA is connected with the ROSA means that the TOSA is connected with the second waveguide coupling module correspondingly connected with the ROSA through the correspondingly connected first waveguide coupling module and the optical interconnection layer.

11. The optical interconnection backboard according to claim 10, wherein,
when P is an even number, each Crossbar has (P+1)*K pairs of electrical transmitting and receiving interfaces, and the (P+1)*K pairs of electrical transmitting and receiving interfaces comprises:
K pairs of electrical transmitting and receiving interfaces for connecting the backboard sockets, P*K electrical transmitting and receiving interfaces for connecting the TOSAs and P*K electrical transmitting and receiving interfaces for connecting the ROSAs;
each TOSA comprises P*K/2 lasers, and
each ROSA comprises P*K/2 photoelectric detectors; and
when P is an odd number, each Crossbar has K*P pairs of electrical transmitting and receiving interfaces, and the K*P pairs of electrical transmitting and receiving interfaces comprises:
K pairs of electrical transmitting and receiving interfaces for connecting the backboard sockets, (P-1)*K electrical transmitting and receiving interfaces for connecting the TOSAs and (P-1)*K electrical transmitting and receiving interfaces for connecting the ROSAs;
each TOSA comprises (P-1)*K/2 lasers, and
each ROSA comprises (P-1)*K/2 photoelectric detectors.

12. The optical interconnection backboard according to claim 11, wherein
the Crossbars are further configured to communicate with a central Control Unit, CU, through the electrical lines of the PCB to implement cross scheduling between different electrical transmitting and receiving interfaces.

13. A transmission device, comprising one or more service boards and further comprising:
the optical interconnection backboard according to any one of claims 1-12, wherein
Crossbars in the optical interconnection backboard are connected with the service boards in a one-to-one corresponding manner.

14. A signal scheduling method, implemented on the basis of the optical interconnection backboard according to any one of claims 1-12 and comprising:
correspondingly transmitting, by the Crossbar, a received electrical signal to connected TOSA or electrical lines of the Printed Circuit Board, PCB, according to a predetermined cross configuration strategy;
modulating, by the TOSA, the electrical signal into an optical signal, and then transmitting the optical signal to the optical interconnection layer through the first waveguide coupling module;
coupling, by the second waveguide coupling module, the optical signal transmitted by the optical interconnection layer to the ROSA; and
converting, by the ROSA, the optical signal into an electrical signal, and then transmitting the electrical signal to the connected Crossbar.

15. The signal scheduling method according to claim 14, wherein the electrical signal received by the Crossbar comprises:
an electrical signal received through the electrical lines of the PCB and an electrical signal received through the connected ROSA.
